(19) Europäisches Patentamt

European Patent Office

Office européen des brevets

(11) **EP 1 093 222 A1**

## (12) EUROPEAN PATENT APPLICATION
published in accordance with Art. 158(3) EPC

(43) Date of publication:
18.04.2001 Bulletin 2001/16

(51) Int. Cl.[7]: **H03G 1/04**, H03F 1/02,
H03F 1/32, H04B 1/04,
H04B 1/18

(21) Application number: 00909662.9

(22) Date of filing: 16.03.2000

(86) International application number:
PCT/JP00/01591

(87) International publication number:
WO 00/60736 (12.10.2000 Gazette 2000/41)

(84) Designated Contracting States:
AT BE CH CY DE DK ES FI FR GB GR IE IT LI LU
MC NL PT SE

(30) Priority: 01.04.1999 JP 9542599

(71) Applicant:
MATSUSHITA ELECTRIC INDUSTRIAL CO., LTD.
Kadoma-shi, Osaka 571-8501 (JP)

(72) Inventor: KINOMURA, Masahiro
Hamamatsu-shi, Shizuoka 435-0031 (JP)

(74) Representative:
Grünecker, Kinkeldey,
Stockmair & Schwanhäusser
Anwaltssozietät
Maximilianstrasse 58
80538 München (DE)

## (54) TRANSMITTER AND RECEIVER

(57) A portable telephone of the present invention detects a load fluctuation in real time to compensate the fluctuation when a load of an antenna fluctuate sharply. Characteristic curves of power efficiency and a gain of a power amplifier are described on the Smith chart with the curves superimposed thereon. An existence area of an operating point of an amplifier on the Smith chart is estimated on the basis of a measurement result of a current and/or a gain of an amplifier. Then, a direction of the fluctuation and a level of the fluctuation of input impedance of an amplifier are judged by employing impedance information of the Smith chart. Then, a variable load circuit is controlled so as to compensate the fluctuation.

FIG.1

**Description**

Technical Field

The present invention relates to a transmitter and a receiver. More particularly, the present invention relates to a portable transmitter and a portable receiver employed for mobile communication. Background Art

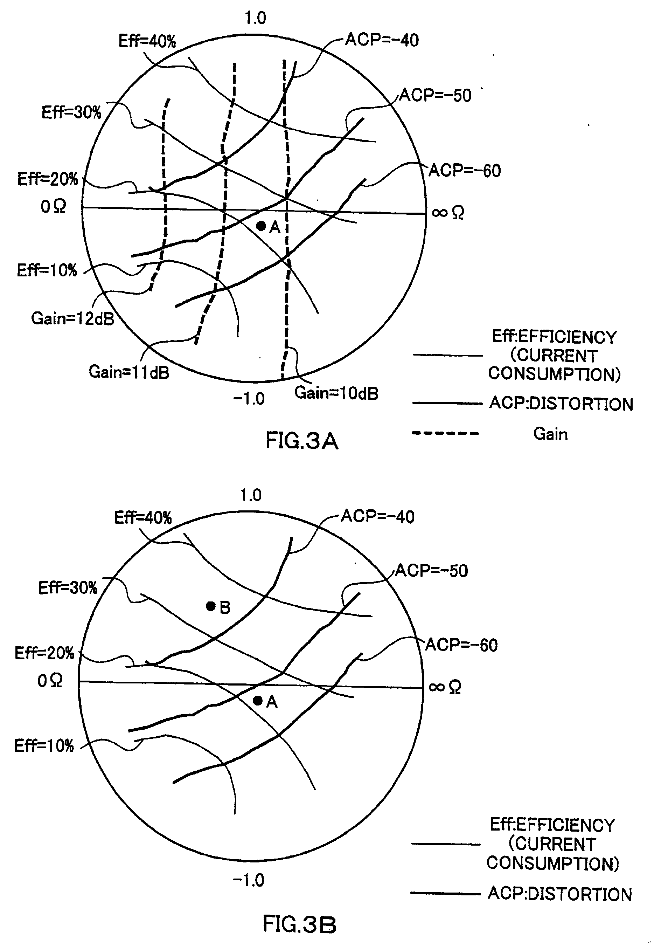

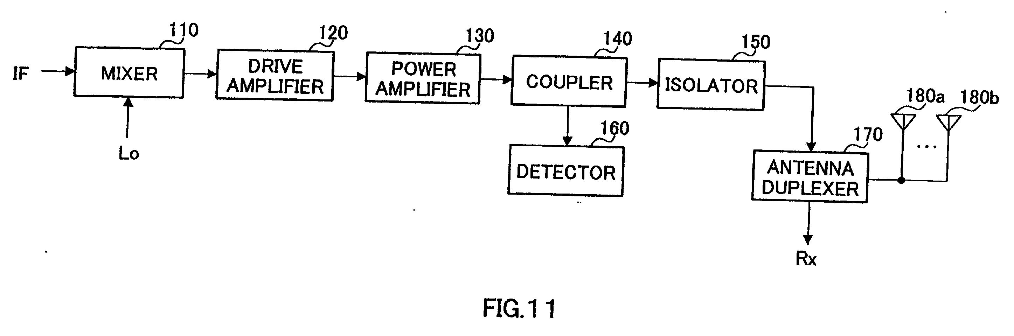

One example of a configuration of a radio transmitter is illustrated in FIG. 11. Such a configuration of the radio transmitter is described in, for instance, FIG. 3 of the Japanese Patent Application Laid-Open No. HEI 7-254864.

In a radio transmitter of FIG. 11, a mixer 110 converts an intermediate-frequency amplified signal (IF) into a high-frequency signal (RF) by mixing a local oscillation signal (Lo) with the intermediate-frequency amplified signal (IF). The high-frequency signal is amplified by a drive amplifier 120 and a power amplifier 130.

A coupler 140 branches a part of an output of the power amplifier 130 to supplies to a detector 160 for monitoring a level.

An isolator 150 possesses a function of permitting an electromagnetic wave in one direction to be passed through the isolator 150 itself without damping the electromagnetic wave, while the isolator 150 possesses a function for absorbing power of the electromagnetic wave in an opposite direction of the above one direction. According to the function, it is prevented that signals received by antennas 180a and 180b enter into the power amplifier 130.

Further, since the isolator 150 exists, even though a load of the antennas 180a and 180b fluctuates, the power amplifier 130 does not receive a bad influence thereof, thus operation of the power amplifier 130 does not become unstable state. Further, deterioration of S/N of an output signal of the power amplifier 130 is prevented.

The antenna duplexer 170 switches transmission to reception and vice versa with respect to at least one antenna element.

As described above, in the radio transmitter illustrated in FIG. 11, it is possible to stabilize a characteristic of the power amplifier 130, since the isolator 150 is provided for the radio transmitter. However, the isolator 150 causes a power loss and increase of an occupied area of circuits.

Consequently, it is necessary to increase an output level of the power amplifier 130 beforehand in anticipation of the loss. As the output level of the power amplifier 130 is increased, power consumption of the power amplifier 130 is also increased, and an amount of distortion of the power amplifier is also increased.

When the isolator 150 is removed, a problem of a power loss or a problem of an occupied space is solved, however, in the meantime, un-stabilization of a characteristic of a power amplifier is brought. Particularly, in the case of a mobile terminal such as a portable telephone, a usage environment is changed variously, the loads (loads of antennas 180a and 180b) of the power amplifier fluctuate easily in company with change of the usage environment.

For instance, when a telephone apparatus body is brought close to the human body, or when the apparatus body is employed on a metallic desk, capacitive coupling is induced between an antenna of a portable telephone apparatus and a human body, or the metallic plate, so that a load of a transmitter fluctuates largely.

Such load fluctuations induce mismatching of impedance between an antenna and a transmission signal path, so that it causes unnecessary reflected waves. Accordingly, a VSWR characteristic of an antenna deteriorates with deterioration of communication quality.

Furthermore, a similar problem occurs also in a receiver.

The present invention is achieved to overcome such problems. Accordingly, an object of the present invention is to provide a transmitter and a receiver in which a fluctuation of a load is suppressed without employing an isolator, and to realize low distortion, low power consumption and reduction of occupied space with respect to a transmitter or a receiver.

Disclosure of Invention

In a transmitter and/or a receiver of the present invention, physical quantity with respect to an amplifier, namely fluctuation of current amount and/or a gain of the amplifier is detected, so that an existence area in which an operating point of the amplifier exists on the Smith chart is estimated on the basis of the physical quantity. According to this operation, a direction of the fluctuation and/or a level of the fluctuation of a load (output impedance of amplifier) of a transmitter, and/or fluctuation of a noise factor or so forth become clear.

Namely, it is possible to detect a fluctuation of a load of a transmitter and/or a receiver in real time by using a simple method of detecting a fluctuation of current amount and a gain of an amplifier.

Then the transmitter and the receiver adjust a value of a load of a variable load circuit to cause impedance of either an input side or an output side of an amplifier to be varied. Namely, the transmitter and the receiver perform a kind of negative feedback control so as to suppress a fluctuation of the impedance with respect to output impedance of the amplifier.

Accordingly, the fluctuation of the load of the transmitter and the receiver is relieved, thus sharp deterioration of communication quality is avoided. Consequently, it becomes possible to remove an isolator. Consequently, it is possible to reduce an occupied area of circuits. Further, it is possible to reduce power consumption of a circuit.

Furthermore, since compensation in real time against fluctuations of a load of a transmitter is performed, a characteristic of a power amplifier is stabilized.

For instance, in one aspect of a transmitter of the present invention, a fluctuation of impedance of a transmitter is detected from a fluctuation of an operating current and a gain of an amplifier, then the fluctuation of the impedance is corrected in real time. Accordingly, it is possible to obtain a stabilized characteristic, thus the isolator becomes unnecessary.

Furthermore, in another aspect of a transmitter of the present invention, a variable gain amplifier is arranged before a power amplifier. When control information of the variable gain amplifier is utilized, it is possible to know a level of an input signal of the power amplifier accurately. For that reason, a gain of the power amplifier can be known accurately. Accordingly, detection accuracy of a fluctuation of a load of a transmitter is improved.

In another aspect of a transmitter of the present invention, the transmitter estimates an existence area in which an operating load point exists on the Smith chart, and which adjusts a load of a variable load circuit in the direction to relieve the fluctuation of the operating load point.

Namely, according to the Smith chart, a locus of a complex impedance of a load can be found. Accordingly, an existence area in which an operating point exists after fluctuation on the Smith chart is estimated from a current and a gain of an amplifier. Then, the transmitter and the receiver adjusts the variable load in the direction to compensates the fluctuation. For that reason, it is possible to realize excellent impedance matching between an antenna and communication transmission path by using a circuit with simple configuration.

In another aspect of a transmitter of the present invention, a variable load circuit connected in parallel to a signal line is provided to adjust impedance of a transmitter.

Input-output impedance of a portable telephone easily fluctuates due to the affection of capacitive coupling between an antenna and the human body and so forth. However, when a transmitter of the present invention is employed, also in a portable telephone, it is always possible to obtain a stabilized communication characteristic.

In an aspect of a receiver of the present invention, the receiver detects a direction of a fluctuation and a level of fluctuation of input impedance of an amplifier included in the receiver on the basis of a current consumption of the amplifier. Then, the receiver adjusts a load of a variable load circuit so as to compensate fluctuations of input impedance of the amplifier.

An amplifier placed on an initial stage of a receiver, particularly a low noise amplifier is sensitive to a fluctuation of input impedance, thus the characteristic of the low noise amplifier is easy to fluctuate due to a affection of the fluctuation. Accordingly, stabilization of input impedance with the negative feedback control employed in the present invention is effective. Accordingly, it is possible to stabilize a reception characteristic of a portable telephone.

Communication apparatus provided with both of the transmitter and the receiver of the present invention is always capable of securing excellent transmission and reception because performance is stabilized.

Brief Description of Drawings

FIG. 1 is a block diagram of a principal section of a receiver according to an embodiment 1 of the present invention;
FIG. 2 is a circuit diagram illustrating a specific configuration example of a principal section of a variable load circuit and a control circuit in the embodiment 1;
FIG. 3A is a view illustrating a position of an operating load point (before fluctuation) on the Smith chart in the embodiment 1;
FIG. 3B is a view illustrating a position of an operating load point (after fluctuation) on the Smith chart in the embodiment 1;
FIG. 4 is a block diagram illustrating a configuration of a principal section of a receiver according to an embodiment 2;
FIG. 5 is a view illustrating positions (before fluctuation and after fluctuation) the operating load points on the Smith chart in the embodiment 2;
FIG. 6 is a block diagram illustrating a configuration of a principal section of a receiver according to an embodiment 3;
FIG. 7 is a view illustrating positions (before fluctuation and after fluctuation) the operating load points on the Smith chart in the embodiment 3;
FIG. 8 is a block diagram illustrating a configuration of a principal section of a receiver according to an embodiment 4;
FIG. 9 is a block diagram illustrating a configuration of a principal section of a receiver according to an embodiment 5;

FIG. 10 is a flowchart for explaining procedure for suppressing load fluctuation of the transmitter and the receiver in the present invention; and

FIG. 11 is a block diagram illustrating a configuration of one example of a conventional transmitter.

Best Node for Carrying Out the Invention

Embodiments of the present invention will be described specifically below with reference to accompanying drawings.

(Embodiment 1)

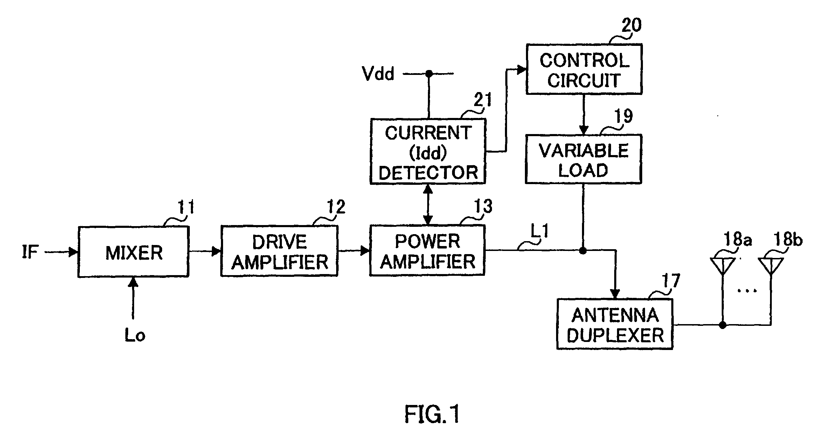

FIG. 1 is a block diagram illustrating a configuration of a principal section of transmitter of an embodiment 1.

This transmitter is, for instance, included in a portable telephone. As illustrated in FIG. 1, the transmitter comprises a mixer 11 for converting an intermediate frequency signal (IF signal) into a high-frequency signal (RF signal), a drive amplifier 12 for amplifying the RF signal, a power amplifier ( power amplification circuit) 13, an antenna duplexer 17 and a plurality of antenna elements 18a and 18b.

The transmitter further comprises a current detector 21 for detecting current consumption (operating current Idd) of the power amplifier 13, a variable load 19, and a control circuit 20 for controlling a load switching of the variable load 19 on the basis of a detecting level of the current detector 21.

Unlike the conventional example, the present embodiment is not provided with the isolator.

In the present embodiment, an amplification factor of the mixer 11 and an amplification factor of the drive amplifier 12 are adjusted into constant values respectively. Accordingly, a voltage level of an input signal of the power amplifier 13 is controlled into a predetermined level. Consequently, it is possible to find a gain of the power amplifier 13 by detecting an output level of the power amplifier 13.

A specific characteristic of the power amplifier 13 is largely affected from a characteristic of a load of an output side. Consequently, according to uses of a power amplifier, a load characteristic of an output side need to be adjusted accurately beforehand. Specifically, in the case of the portable telephone, the load characteristic is varied sharply caused by capacitive coupling and so forth between an antenna and the human body described-above. Accordingly, the control circuit 20 controls (for instance, switching to control) the variable load 19 so as to compensate the sharp variation.

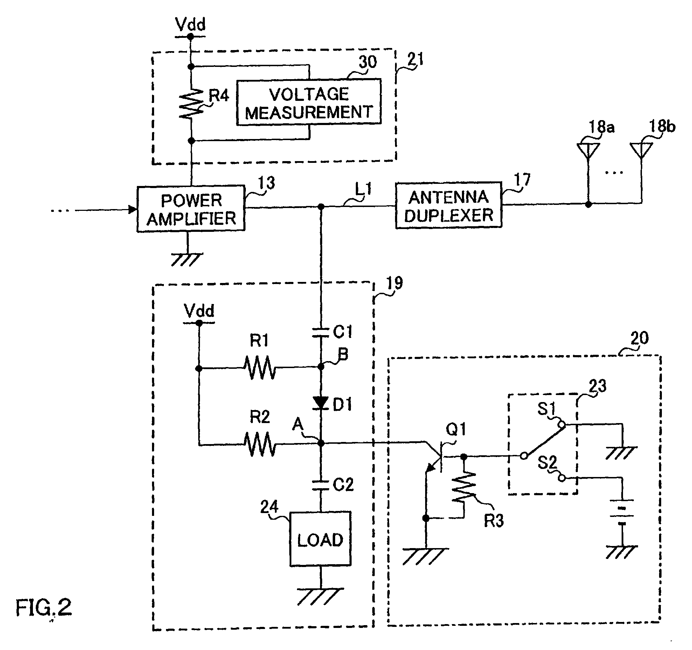

FIG. 2 is a circuit diagram illustrating a configuration example for performing switching control of a load.

The current detector 21 for detecting operating current amount of the power amplifier 13 includes a resistor R4 for current/voltage conversion and a voltage measuring unit 30. A detection signal of the voltage measuring unit 30 is supplied to the control circuit 20.

A switching circuit 23 of the control circuit 20 compares a predetermined threshold value with a level of a detected output of the voltage measuring unit 30, and switches a switch to connect a terminal S1 or S2 according to the comparison result.

When the switch is connected to the terminal S1, an NPN transistor Q1 in the control circuit 20 is turned OFF, while when the switch is connected to the terminal S2, the NPN transistor Q1 in the control circuit 20 is turned ON.

When the NPN transistor Q1 is OFF, an electric potential of both ends A and B of a diode D1 within the control circuit 19 is fixed into Vdd, thus the diode D1 is OFF state. In this state, the variable load 19 is high-impedance state (open state) in view of the signal line L1, consequently an output load of the power amplifier 13 is not affected at all.

Here, in the switching circuit 23, when the switch is connected to the terminal S2, the NPN transistor Q1 turns ON. Then an electric potential of a cathode (point A) of the diode D1 becomes approximately 0V. A fixed voltage Vdd is a voltage of more than 0.7V. Accordingly, the diode D1 is subjected to forward bias, allowing the diode D1 to conduct, thus a load 24 is connected in alternative current fashion to the signal line L1 through DC-cutting capacitors C1 and C2. Accordingly, the load of the power amplifier 13 is varied.

For instance, connection/non-connection between a plurality of loads with different capacitance and signal lines is switched appropriately by switching circuits. For that reason, it is possible to vary a value of the load of the variable load circuit 19 so as to compensate a fluctuation of a load (load of transmitter) of an output side of the power amplifier 13.

Here, there is a problem that how to detect a direction and a level of the fluctuations of the load of the output side of the power amplifier 13.

Hereinafter, the description examines this point.

When the load of the transmitter fluctuates, a characteristic itself of the power amplifier 13 is varied while being affected by the fluctuation. When the fluctuation of the characteristic is superimposed on the Smith chart to examine, it is possible to estimate a direction of variation of a load (namely, increase or decrease) and a level of the fluctuation of the load.

FIG. 3A and FIG. 3B are views illustrating a mutual relationship among respective characteristic lines of a gain (in drawings, referred to as "Gain") of the power amplifier 13, power efficiency (referred to as "eff") and a distortion characteristic of signals (referred to as "ACP") on the Smith chart.

Namely, concerning the power amplifier 13, a relationship between impedance (load) of an output side and respective characteristics of a gain, power efficiency arid a distortion characteristic is investigated beforehand. It is assumed that a relationship illustrated in FIG. 3 is obtained as a result of the above-described investigation.

In addition, the "gain" of the power amplifier 13 is a ratio of an input voltage level to an output voltage level.

Further, the "power efficiency" is a ratio of an input power to an output power against current consumption of the power amplifier 13. The "power efficiency" is represented by a following expression (1):

$$\text{"power efficiency"} = (\text{output power} - \text{input power}) / (Vdd \times Idd) \tag{1}$$

Here, Vdd is a power-supply voltage, and Idd is an operating current of the power amplifier.

Moreover, the "input power" of the power amplifier is an effective value of a voltage of an input signal. Amplitude of a base band modulation signal is fixed. When a voltage gain of the drive amplifier 12 arranged in front of the power amplifier 13 is fixed, power of the input signal of the power amplifier 13 is determined with the only one value given in accordance with the above state.

Moreover, in the present embodiment, it is assumed that the "output power" of the power amplifier 13 is fixed.

A level of an input signal of the power amplifier is a fixed level as described above and the level is known. Further, an output level of the power amplifier is fixed. Furthermore, a power-supply voltage Vdd is also known.

Consequently, as is clear from the expression (1), the "power efficiency" can be regarded as a function of the Idd (current consumption). Namely, when a value of the current consumption Idd is known, the power efficiency (eff) also can be known.

Further, the distortion characteristic (ACP) is a synonym of adjacent-channel leakage power. Namely, the adjacent-channel leakage power is a ratio of power of a transmission signal to power of signal which is induced to a frequency band corresponding to an adjacent channel according to an output of the transmission signal.

The smaller is a value of the adjacent-channel leakage power (distortion characteristic: ACP), the larger is distortion quantity of the transmission signal.

Here, it is assumed that a present operating load point is a point of "A". In this case, the "power efficiency (eff)" is not less than 20%, the "gain" is not less than 10dB, further, the "ACP (distortion)" is not more than -50dB.

Here, it is assumed that the operating point is shifted to a point "B" according to load fluctuations as illustrated in FIG. 3B.

In this case, the "ACP (distortion)" becomes not more than -40dB, thus the distortion increases sharply. In the meantime, the "power efficiency (eff)" becomes not less than 30%, thus the "power efficiency (eff)" is increased. As is known from the above-described expression (1), an increase of the "power efficiency (eff)" means that, namely, the current consumption Idd of the power amplifier is decreased.

Consequently, in a circuit illustrated in FIG. 1, when the current detector 21 detects quantity of the current (Idd), it is possible to estimate that current amount of the control circuit 20 is decreased and an operating point of the power amplifier exists in the neighborhood of bounds of "B" on the Smith chart from degree of a decrease of current quantity.

Since the Smith chart represents a locus of a complex impedance (or admittance) of a signal line, when a fluctuating direction of an operating point and rough fluctuation quantity are known, fluctuations and degrees thereof regarding the impedance are known. Accordingly, the control circuit 20 switches to control the variable load 19 so as to compensate fluctuation of the impedance (load).

Thus, even though the transmitter is not provided with an isolator, it is possible to estimate a direction and a level of load fluctuations when the current consumption of the power amplifier is only detected. Then, the load of the output side of the amplifier is controlled so as to compensate the fluctuations.

As described above, a specific characteristic of the power amplifier is stabilized, thus resulting in occurrence of no problem. Further, this disposition can be realized by using a relatively simple circuit. Accordingly, it is possible to reduce occupied area of a circuit, and decrease power consumption of a circuit.

(Embodiment 2)

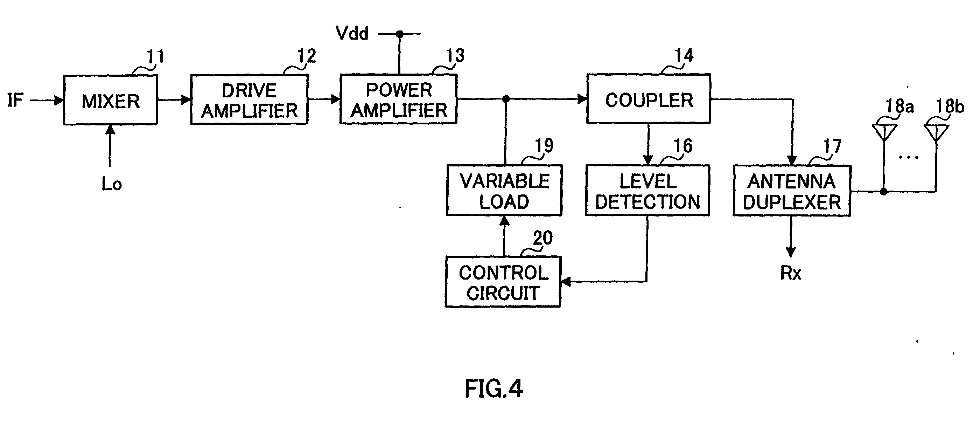

FIG. 4 is a block diagram of a transmitter according to an embodiment 2. In FIG. 4, the same reference signs are added to the common part of the circuit of FIG. 1.

A configuration of the transmitter of FIG. 4 is fundamentally the same as the circuit of FIG. 1. However, in FIG. 1, the transmitter is provided with the current detector 21, while, in FIG. 4, different point is that the transmitter is provided with a level detector 16 for detecting an output level of the power amplifier 13 in stead of the current detector 21.

The level detector 16 functions to detect power of an output signal while performing detection of the output signal of the power amplifier 13.

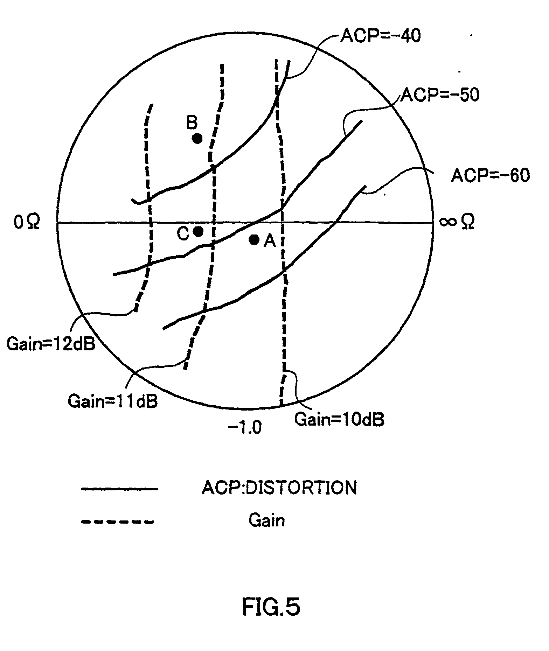

As illustrated in FIG. 5, when an operating load point has shifted from "A" to "B" on the Smith chart, a distortion (ACP) of signals is increased sharply.

On this occasion, a gain of the power amplifier 13 increases from not less than 10dB to not less than 11dB. Consequently, when the operator watches the gain of the power amplifier 13, it is possible to estimate a direction and a level of the load fluctuations.

Accordingly, in a transmission circuit of FIG. 4, the transmitter causes a part of an output signal of the power amplifier 13 to branch off from the output signal by a coupler 14, and a voltage level (namely output power) of the branched signal is detected by the level detector 16. When an output level of the power amplifier 13 is known, a gain of the power amplifier 13 is known because an input voltage level is fixed.

The control circuit 20 determines the fluctuation of the operating load point according to the fact that the gain of the power amplifier 13 has increased sharply, followed by switching to control the variable load 19 so as to compensate the fluctuations. According to this disposition, the same effect as the embodiment 1 is obtained.

(Embodiment 3)

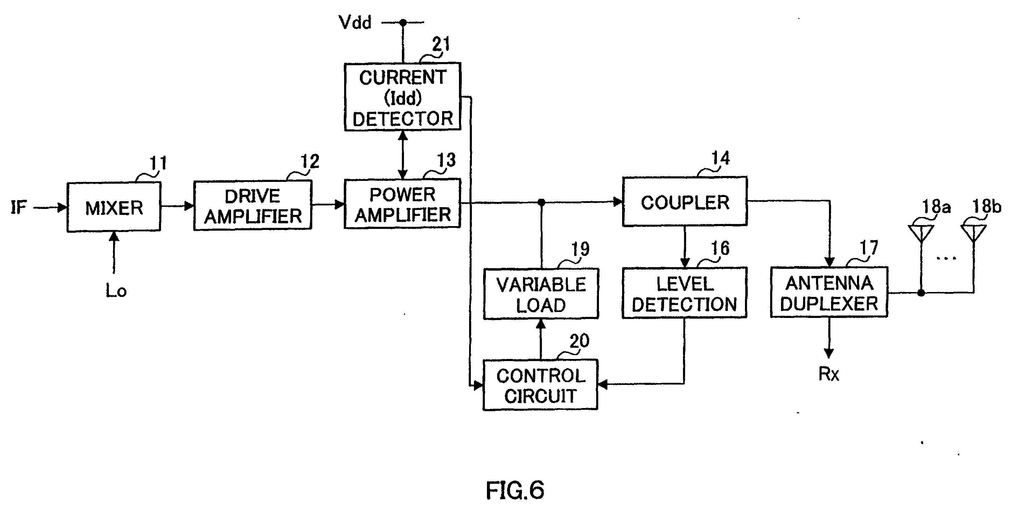

FIG. 6 is a block diagram of a receiver of a present embodiment.

A fundamental configuration of the receiver in the present embodiment is the same as that of the above described embodiment. However, present embodiment differs from the previous embodiment in that the present embodiment uses the current detector 21 and the level detector 16 at the same time.

Namely, the previous embodiment estimates whether an operating load point exists in which position on the Smith chart while employing either a current of the power amplifier or a gain of the power amplifier.

However, accuracy of the estimation is not always high by employing any one parameter of the two. Accordingly, in the present embodiment, both physical quantity (parameters) are employed.

For instance, when a state of a load of an output side is estimated from only a variation of a gain of the power amplifier, it is impossible to discriminate between an operating load point "B" and an operating load point "C" of FIG. 5. Because the two load points have a point in common in that the both gains are not less than 11dB.

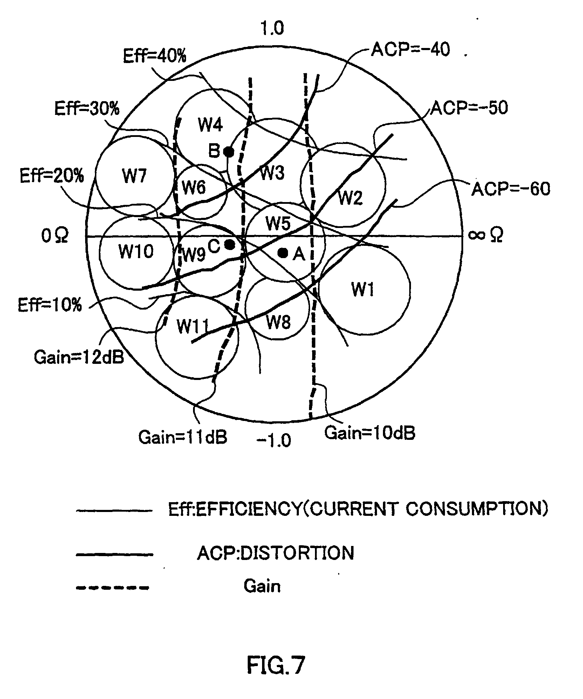

Accordingly, both the current detector 21 and the level detector 16 are employed at the same time. As illustrated in FIG. 7, it is possible to estimate an existence extent (existence area) of an operating load point more finely due to combination of two parameters of a current and a gain of the power amplifier.

Namely, as illustrated in FIG. 7, a relationship between respective a current of the power amplifier (namely, "power efficiency"), a gain and a distortion of a transmission signal (ACP), and a value of a load of an output side of the power amplifier is investigated beforehand, and the information is recorded on the Smith chart. Accordingly, an area on the Smith chart is divided into 11 pieces of area of "W1 to W11" on the basis of two parameters.

Thus when an area is divided finely on the Smith chart, it is possible to detect the operating load points "B" and "C" on the Smith chart as the operating load points clearly distinguished. Accordingly, detection accuracy of the load fluctuations is improved. For that reason, accuracy of control of the variable load 19 for compensating the fluctuations is improved. Further, a specific characteristic of an output load of the power amplifier is more stabilized.

(Embodiment 4)

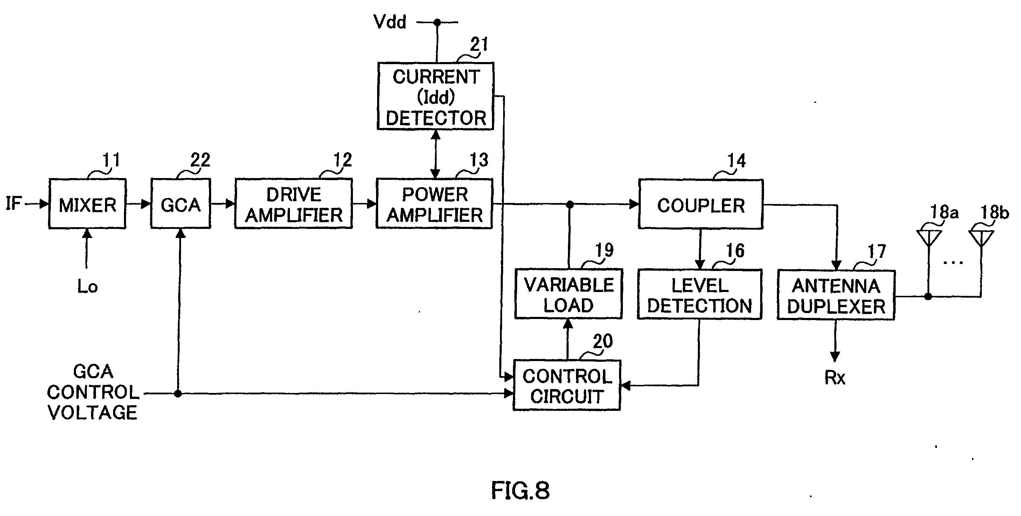

FIG. 8 is a block diagram of a receiver of an embodiment 4.

A fundamental configuration is the same as that of the previous embodiment. However, in the present embodiment, a gain control amplification circuit (variable gain amplifier: GCA) 22 is provided in front of the power amplifier 13.

Further, gain control information of the variable gain amplifier 22 is employed as auxiliary information when the "power efficiency (eff)" of the power amplifier 13 is found, so that it is possible to perform calculation of the "power efficiency (eff)" accurately.

Namely, the "power efficiency (eff)" of the power amplifier can be found by the above-described expression (1). Consequently, when the "power efficiency (eff)" is found, an input voltage of the power amplifier should be known.

However, in a system whose dynamic range is broad such as a communication apparatus of a CDMA system, usually, a level inputted to the power amplifier is varied, thus in some times, it is difficult to know actually the input level accurately.

Accordingly, when information of a gain control voltage of the variable gain amplifier (GCA) 22 provided before the power amplifier 13 is employed, it is possible to know an input voltage level of the power amplifier 13 accurately.

Further, an output level of the power amplifier 13 is detected by the level detector 16 of FIG. 8. Furthermore, an operating current (Idd) of the power amplifier 13 can be known from the current detector 21 of FIG. 8.

Accordingly, the "power efficiency (eff)" of the power amplifier 13 can be found accurately. Consequently, a position of an operating point on the Smith chart can be estimated more accurately.

Further, since an input voltage and an output voltage of the power amplifier 13 are detected accurately, also a "gain" of the power amplifier 13 can be detected accurately. Accordingly, when two kinds of information of the "power efficiency (eff)" and the "gain", it is possible to estimate a position of an operating load point on the Smith chart more accurately.

According to this disposition, it is possible to perform switching control of the variable load 19 more exactly.

(Embodiment 5)

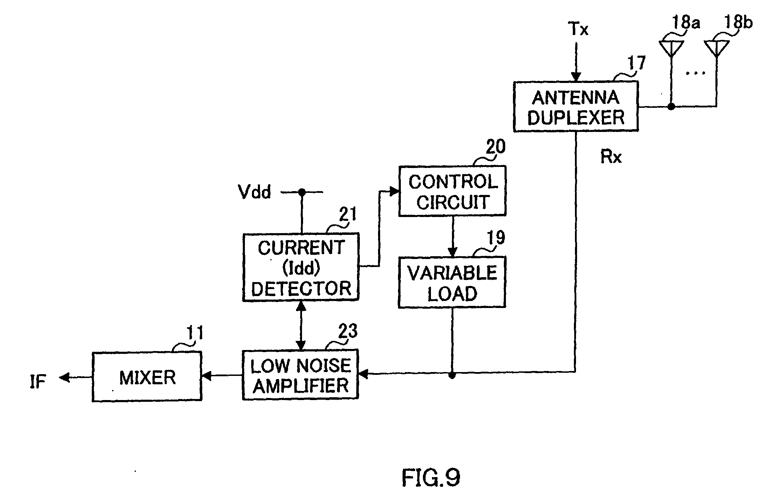

FIG. 9 is a block diagram illustrating a configuration of a principal section of a receiver according to an embodiment 5.

As illustrated in FIG. 9, the receiver has a mixer 11, an antenna duplexer 17, antenna elements 18a and 18b, a variable load 19, a control circuit 20, a current detector 21 and a low noise amplifier (low noise circuit) 23.

The low noise amplifier 23 amplifies signals received by the antenna elements 18a and 18b. A noise factor (NF) of the low noise amplifier 23 is varied largely according to a load characteristic of an input side. Since the noise factor of the low noise amplifier largely affects reception performance of a receiver, it is important in a portable telephone and so forth that a receiver causes an input load characteristic to be stabilized.

The low noise amplifier 23 has a specific characteristic that an operating current (current consumption) is varied in accordance with a state of an input side load. A fluctuation of a load characteristic of an input side of the low noise amplifier 23 is detected from a variation of an operating current of the low noise amplifier 23 in the same way as the previous embodiment while utilizing such characteristic. Then, the control circuit 20 switches to control the variable load 19 so as to compensate the fluctuations.

According to this disposition, although when a load characteristic of an antenna is varied, a noise factor characteristic (NF) of the low noise amplifier is stabilized, an effect that it is always possible to realize an excellent reception state is obtained.

Communication apparatus (in particular, portable apparatus) which has both of a transmitter and a receiver of the present invention, although a load fluctuation of an antenna occur, it is always possible to obtain stabilized transmission/reception. Further, since an isolator can be removed from a transmission circuit, it is advantageous in that an occupied area of a circuit is reduced.

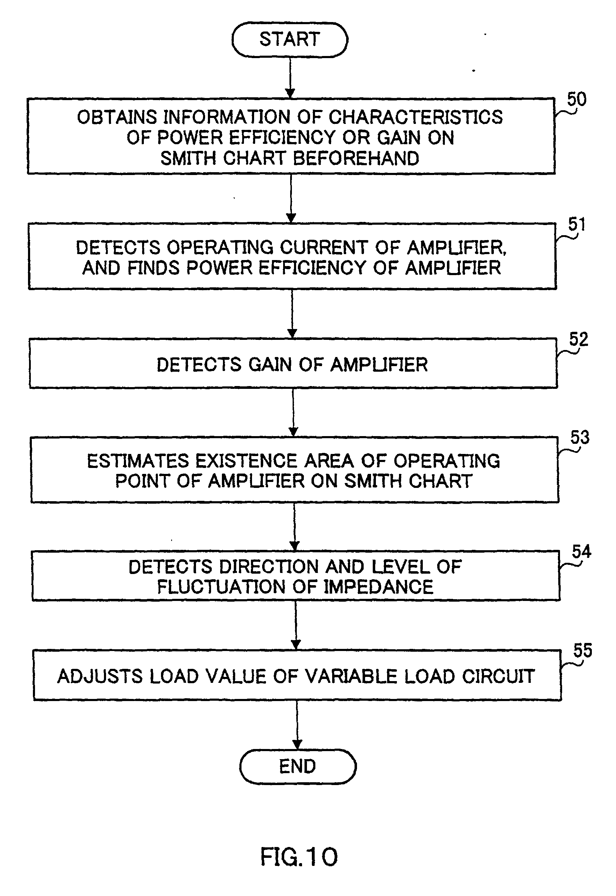

Procedure for compensating fluctuations of loads of a transmitter and a receiver is illustrated in FIG. 10 while employing two kinds of information of a current consumption and a gain of an amplifier.

Namely, information of power efficiency (eff) of an amplification circuit or a specific characteristic of a gain on the Smith chart is obtained beforehand (STEP 50). Then, an operating current (current consumption) of the amplification circuit is detected, followed by obtaining power efficiency (eff) of the amplification circuit on the basis of the detected current value (STEP 51).

Further, a gain of the amplification circuit is detected (STEP 52). Then, an existence area of an operating point of the amplification circuit on the Smith chart is estimated (STEP 53). Next, a direction and a level of fluctuations of an impedance of either an input side or an output side of the amplification circuit are detected (STEP 54). Then, a load value of a variable load circuit is adjusted so as to compensate the fluctuations of the impedance (STEP 55).

As above, the embodiments of the present invention are described. However, the present invention is not limited by these embodiments. Various modifications and application are possible.

For instance, in a mobile communication system such as a wide-band CDMA (W-CDMA) system, in frequent cases, transmission and reception are performed at the same time. In the state where transmission and reception are performed at the same time, it is also possible to compensate fluctuations of an input load characteristic of a low noise amplifier for reception while employing information of a current consumption and a gain detected by an power amplifier for transmission.

As described above, according to the present invention, a fluctuation of an output load and/or an input side load of an amplification circuit is obtained by utilizing a representative parameter (physical characteristic) of the amplification circuit, and then, negative feedback control is performed to stabilize a load characteristic to the fluctuations. Accordingly, it is possible to obtain a stabilized transmission/reception characteristic. Further, as a transmitter, there is an effect that an isolator can be removed.

This application is based on the Japanese Patent Application NO. HEI 11-95425 filed on April 1, 1999, entire content of which is expressly incorporated by reference herein. Industrial Applicability

As described above, the present invention is particularly useful while applying to a transmitter and a receiver in mobile communication.

**Claims**

1. A transmitter comprising:

   a power amplifier that amplifies a high-frequency signal;
   at least one variable load circuit connected to an output terminal of said power amplifier;
   a control circuit which detects a direction and a level of fluctuations on the basis of at least one of an operating current and a gain of said power amplifier when a load state of an output side of said power amplifier fluctuates, and which adjusts a load of said variable load circuit so as to compensate the fluctuation; and
   at least one antenna element for transmitting a signal amplified by said power amplifier.

2. A transmitter according to claim 1, wherein said control circuit estimates an existence area in which an operating point of said amplifier exists on the Smith chart, and adjusts the load of said variable load circuit so as to alleviate a fluctuation of the operating point.

3. A transmitter according to claim 1, wherein said variable load circuit is provided between said output terminal of said power amplifier and a reference electric potential.

4. A mobile communication apparatus mounted with a transmitter according to claim 1.

5. A transmitter comprising:

   a gain control amplifier which is capable of controlling a gain with a gain control signal;
   a power amplifier for further amplifying a signal amplified by said gain control amplifier;
   at least one variable load circuit connected to an output terminal of said power amplifier;
   a control circuit that detects a direction as well as a level of fluctuations on the basis of at least one of either an operating current or said gain control signal in said gain control amplifier when a load state of an output side of said power amplifier fluctuates and adjusts a load of said variable load circuit so as to compensate fluctuations of a load state of said power amplifier; and
   at least one antenna element for transmitting signals amplified by said power amplifier.

6. A transmitter according to claim 5, wherein said control circuit estimates an existence area in which an operating point of an amplifier exists on the Smith chart, and which adjusts a load of said variable load circuit so as to alleviate fluctuations of the operating point.

7. A transmitter according to claim 5, wherein said variable load circuit is provided between said output terminal of said power amplifier and a reference electric potential.

8. A mobile communication apparatus which is mounted with a transmitter according to claim 5.

9. A receiver comprising:

   an antenna element for receiving transmitted signal;
   an amplifier for amplifying a signal received by said antenna element;
   at least one variable load circuit connected to an input terminal of said amplifier; and
   a control circuit which detects a direction and a level of fluctuations on the basis of an operating current of said amplifier when a load state of an output side of said power amplifier fluctuates, and which adjusts a load of said variable load circuit so as to compensate fluctuation of a load state of said power amplifier.

10. A mobile communication apparatus which is mounted with a receiver according to claim 9.

11. A method for compensating a fluctuation in a load of an input side and/or a load of an output side of an amplifier comprising the steps of:

   obtaining information on a characteristic of either power efficiency or a gain of said amplifier on the Smith chart beforehand;

detecting an operating current of said amplifier and obtaining said power efficiency by employing the detected current value;

detecting the gain of said amplifier;

estimating an existence area in which an operating point of said amplifier exists on the Smith chart by employing the detected power efficiency and gain;

detecting a direction and a level of a fluctuation of impedance of either an input side or an output side of said amplifier on the basis of information on the existence area of the estimated operating point; and

adjusting a load value of a variable load circuit connected to either an input terminal or an output terminal of said amplifier so as to compensate the fluctuation of said impedance.

12. A method for compensating a fluctuation of a load of an input side and/or a load of an output side of an amplifier according to claim 11, wherein said method utilizes the current value of said amplifier, and also gain control information on a gain control amplifier provided before said amplifier in order to obtain power efficiency of said amplifier.

FIG.1

FIG.2

FIG.3A

FIG.3B

FIG.4

IF → MIXER (11) ← Lo → DRIVE AMPLIFIER (12) → POWER AMPLIFIER (13) → COUPLER (14) → ANTENNA DUPLEXER (17) → Rx

Vdd → POWER AMPLIFIER (13)

COUPLER (14) → LEVEL DETECTION (16) → CONTROL CIRCUIT (20) → VARIABLE LOAD (19)

ANTENNA DUPLEXER (17) → 18a, 18b

FIG.5

FIG.6

EP 1 093 222 A1

FIG.7

IF → MIXER (11) → GCA (22) → DRIVE AMPLIFIER (12) → POWER AMPLIFIER (13) → COUPLER (14) → ANTENNA DUPLEXER (17) → 18a, 18b → Rx

Lo → MIXER

Vdd → CURRENT (Idd) DETECTOR (21)

COUPLER → LEVEL DETECTION (16)

VARIABLE LOAD (19)

CONTROL CIRCUIT (20)

GCA CONTROL VOLTAGE

FIG.8

FIG.9

START

OBTAINS INFORMATION OF CHARACTERISTICS
OF POWER EFFICIENCY OR GAIN ON
SMITH CHART BEFOREHAND
50

DETECTS OPERATING CURRENT OF AMPLIFIER,
AND FINDS POWER EFFICIENCY OF AMPLIFIER
51

DETECTS GAIN OF AMPLIFIER
52

ESTIMATES EXISTENCE AREA OF OPERATING
POINT OF AMPLIFIER ON SMITH CHART
53

DETECTS DIRECTION AND LEVEL OF
FLUCTUATION OF IMPEDANCE
54

ADJUSTS LOAD VALUE OF VARIABLE LOAD CIRCUIT
55

END

FIG.10

FIG.11

# INTERNATIONAL SEARCH REPORT

| | International application No. |
|---|---|
| | PCT/JP00/01591 |

A. CLASSIFICATION OF SUBJECT MATTER
      Int.Cl⁷   H03G 1/04, H03F 1/02, H03F 1/32,
                H04B1/04, H04B1/18

According to International Patent Classification (IPC) or to both national classification and IPC

B. FIELDS SEARCHED

Minimum documentation searched (classification system followed by classification symbols)
      Int.Cl⁷   H03G 1/04, H03F 1/02, H03F 1/32,
                H04B1/04, H04B1/18

Documentation searched other than minimum documentation to the extent that such documents are included in the fields searched
      Jitsuyo Shinan Koho       1926-1996    Jitsuyo Shinan Toroku Koho   1996-2000
      Kokai Jitsuyo Shinan Koho 1971-2000    Toroku Jitsuyo Shinan Koho   1994-2000

Electronic data base consulted during the international search (name of data base and, where practicable, search terms used)
      WPI/L (amplifier,power supply current)

C. DOCUMENTS CONSIDERED TO BE RELEVANT

| Category* | Citation of document, with indication, where appropriate, of the relevant passages | Relevant to claim No. |
|---|---|---|
| A | WO, 94023491, A (QUALCOMM INCORPORATED), 13 October, 1994 (13.10.94), Full text; Fig. 4 & JP, 08-501197, A & US, 5442322, A | 1-12 |
| A | JP, 7-254864, A (Fujitsu Limited), 03 October, 1995 (03.10.95), Full text; Fig. 3 | 1-12 |
| A | JP, 02-097227, A (Canon Inc.), 09 April, 1990 (09.04.90), Full text | 1-12 |

☐ Further documents are listed in the continuation of Box C.    ☐ See patent family annex.

| Date of the actual completion of the international search | Date of mailing of the international search report |
|---|---|
| 13 June, 2013 (13.06.13) | 04 July, 2000 (04.07.00) |

| Name and mailing address of the ISA/ Japanese Patent Office | Authorized officer |
|---|---|
| Facsimile No. | Telephone No. |

Form PCT/ISA/210 (second sheet) (July 1992)